# EUROPEAN PATENT APPLICATION

(11) **EP 4 672 922 A1**
(43) Date of publication of application: **31.12.2025**
(21) Application number: 24915027.7
(22) Date of filing: 27.11.2024
(51) Int. Cl.: H10F 77/20, H10F 77/30, H10F 77/14, H10F 10/16, H10F 71/00

(54) **SOLAR CELL, MANUFACTURING METHOD THEREFOR AND PHOTOVOLTAIC MODULE**

(30) Priority: 05.01.2024 CN 202410017495
(71) Applicant: Tongwei Solar (Meishan) Co., Ltd., Meishan, Sichuan 620041 (CN)
(72) Inventor: ZHOU, Fan, Meishan, Sichuan 620041 (CN); ZHOU, Hua, Meishan, Sichuan 620041 (CN); HE, Yu, Meishan, Sichuan 620041 (CN)
(74) Representative: Gill Jennings & Every LLP
(86) International application number: PCT/CN2024/134826
(87) International publication number: WO 2025/145811

(57) **Abstract**

Provided in the present application are a solar cell, a manufacturing method therefor and a photovoltaic module. The solar cell comprises: an N-type substrate (1); an N-type diffusion layer (2) on a light-receiving surface of the N-type substrate (1); a patterned first passivated contact structure (3) on the N-type diffusion layer (2), the patterned first passivated contact structure (3) comprising a first dielectric layer (31) having a thickness of less than or equal to 2 nm and an N-type doped polycrystalline silicon layer (32); and a second passivated contact structure (4) on a backside surface of the N-type substrate (1), the second passivated contact structure (4) comprising a second dielectric layer (41) having a thickness of greater than 2 nm and a P-type heavily doped polycrystalline silicon layer (42), a PN junction being formed on the backside surface, the second dielectric layer (41) having a through hole (411), and the doping concentration of the P-type heavily doped polycrystalline silicon layer (42) being 5×10¹⁸ to 3×10²⁰ atoms/cm³. A first functional layer (5) and a first electrode (7) are sequentially provided on the N-type diffusion layer (2) and the first passivated contact structure (3), and a second functional layer (6) and a second electrode (8) are sequentially provided on the P-type heavily doped polycrystalline silicon layer (42).

## Description

This application claims priority to Chinese patent application No. 202410017495.2, entitled "SOLAR CELL, MANUFACTURING METHOD THEREFOR AND PHOTOVOLTAIC MODUL" filed on January 05, 2024, the content of which is hereby incorporated by reference in its entirety.

### TECHNICAL FIELD

The present application relates to the field of solar cells, and in particular, to a solar cell, a method for preparing the same, and a photovoltaic module.

### BACKGROUND

Passivated contact solar cells exhibit relatively high photoelectric conversion efficiency among current solar cells and are suitable for industrial application and promotion. However, when manufactured using industrialized production methods, their photoelectric conversion efficiency hits a bottleneck, currently at approximately 25.1%. Due to limitations such as the recombination losses and current transmission losses at the light-receiving surface of these cells, further improvement in photoelectric conversion efficiency is difficult.

Furthermore, any further improvement in the photoelectric conversion efficiency of these solar cells is hindered by product reliability issues caused by structural or process limitations, including high and difficult-to-meet passivation requirements for the light-receiving front surfaces of solar cells, poor ultraviolet stability, high lateral series resistance, etc., all of which lead to poor product reliability.

### SUMMARY

To address the above technical issues, embodiments of the present application provide a solar cell, a preparation method thereof, and a photovoltaic module, aiming to address the difficulty in simultaneous improvements of cell performance indicators and product reliability of the passivated contact solar cells prepared by existing industrialized production methods.

In a first aspect, the present application provides a solar cell, which includes:
an N-type substrate;
an N-type diffusion layer disposed on a light-receiving surface of the N-type substrate;
a patterned first passivating contact structure disposed on the N-type diffusion layer, the first passivating contact structure including a first dielectric layer disposed adjacent to the N-type diffusion layer and an N-type doped polysilicon layer disposed away from the N-type diffusion layer, wherein a thickness of the first dielectric layer is less than or equal to 2 nm;
a second passivating contact structure disposed on an entirety of a back surface of the N-type substrate, the second passivating contact structure including a second dielectric layer disposed adjacent to the N-type substrate and a P-type heavily doped polysilicon layer disposed away from the N-type substrate, with a PN junction being formed between the P-type heavily doped polysilicon layer and the N-type substrate, wherein a thickness of the second dielectric layer is greater than 2 nm, the second dielectric layer has a through-hole that communicates the N-type substrate with the P-type heavily doped polysilicon layer, and a doping concentration of a P-type conductive element in the P-type heavily doped polysilicon layer is in a range from 5×10¹⁸ atoms/cm³ to 3×10²⁰ atoms/cm³;
a first function layer disposed on surfaces of the N-type diffusion layer and the N-type doped polysilicon layer away from the substrate;
a second function layer disposed on a surface of the P-type heavily doped polysilicon layer away from the N-type substrate;
a first electrode extending through the first function layer and forming an ohmic contact with the N-type doped polysilicon layer, wherein a patterned region of the first passivating contact structure is disposed corresponding to a patterned region of the first electrode;
a second electrode extending through the second function layer and forming an ohmic contact with the P-type heavily doped polysilicon layer.

Furthermore, the N-type diffusion layer is a phosphorus diffusion layer, a sheet resistance of the N-type diffusion layer is in a range from 200 Ω/sq to 350 Ω/sq, a thickness of the N-type diffusion layer is in a range from 0.05 µm to 0.5 µm, and a doping concentration of an N-type conductive element in the N-type diffusion layer is in a range from 5×10¹⁸ atoms/cm³ to 1×10²⁰ atoms/cm³.

Furthermore, a portion of the N-type diffusion layer covered by the first passivating contact structure is 0.05 µm to 0.15 µm thicker than a portion of the N-type diffusion layer not covered by the first passivating contact structure.

Furthermore, a thickness of the N-type doped polysilicon layer is in a range from 30 nm to 200 nm, and a thickness of the P-type heavily doped polysilicon layer is in a range from 200 nm to 400 nm.

Furthermore, the N-type doped polysilicon layer is doped with an N-type conductive element, wherein the N-type conductive element includes at least one of a phosphorus element, a germanium element, or a selenium element.

The P-type conductive element includes at least one of a boron element, an indium element, or a gallium element.

Furthermore, a diameter of the through-hole is in a range from 50 nm to 500 nm, and a number of the through-holes is in a range from 1×10⁴ /cm² to 1.6×10⁸ /cm².

Furthermore, a width of the first passivating contact structure is in a range from 20 µm to 110 µm.

Furthermore, a quantity ratio of gridlines of the second electrode to gridlines of the first electrode is in a range from 1.2:1 to 1.6:1.

Furthermore, the first function layer includes a first passivation layer disposed adjacent to the N-type diffusion layer and a first anti-reflection layer disposed away from the N-type diffusion layer.

Furthermore, the second function layer includes a second passivation layer disposed adjacent to the P-type heavily doped polysilicon layer and a second anti-reflection layer disposed away from the P-type heavily doped polysilicon layer.

Furthermore, the first function layer includes the first passivation layer and the first anti-reflection layer, the first passivation layer is a silicon oxide layer, and the first anti-reflection layer is a silicon nitride layer, a silicon oxynitride layer, a silicon oxide layer, or any combination thereof.

In a second aspect, embodiments of the present application provide a method for preparing the solar cell as described in the first aspect, including the following steps:
forming the N-type diffusion layer: diffusing the N-type conductive element on the light-receiving surface of the N-type substrate to obtain the N-type diffusion layer;
forming the passivating contact structure: forming the first dielectric layer and an N-type doped amorphous silicon layer in sequence on a surface of the N-type diffusion layer away from the N-type substrate, and forming the second dielectric layer and a P-type doped amorphous silicon layer in sequence on the back surface of the N-type substrate;
patterning treatment: printing a patterned paste in a preset region of the N-type doped amorphous silicon layer, then performing etching and cleaning to remove the first dielectric layer and the N-type doped amorphous silicon layer not covered in the preset region, and then removing the paste to retain the first dielectric layer and the N-type doped amorphous silicon layer covered in the preset region;
annealing: annealing the N-type substrate after the patterning treatment to convert the N-type doped amorphous silicon layer into the N-type doped polysilicon layer and to convert the P-type doped amorphous silicon layer into the P-type heavily doped polysilicon layer, wherein the first dielectric layer and the N-type doped polysilicon layer form the first passivating contact structure, the second dielectric layer and the P-type heavily doped polysilicon layer form the second passivating contact structure, and the PN junction is formed between the N-type substrate and the P-type heavily doped polysilicon layer;
post-treatment: forming the first function layer on the N-type diffusion layer and the patterned N-type doped polysilicon layer, forming the second function layer on the P-type heavily doped polysilicon layer, forming the first electrode on the first function layer wherein the first electrode extends through the first function layer and forms the ohmic contact with the N-type doped polysilicon layer, and forming the second electrode on the second function layer wherein the second electrode extends through the second function layer and forms the ohmic contact with the P-type heavily doped polysilicon layer.

Furthermore, the step of forming the N-type diffusion layer includes: performing drive-in diffusion of the N-type conductive element on the light-receiving surface of the N-type substrate using nitrogen gas carrying oxygen and a gas source containing the N-type conductive element, thereby forming the N-type diffusion layer with a thickness in a range from 0.05 µm to 0.5 µm, wherein a sheet resistance of the N-type diffusion layer is in a range from 200 Ω/sq to 350 Ω/sq, and a doping concentration of the N-type conductive element in the N-type diffusion layer is in a range from 5×10¹⁸ atoms/cm³ to 1×10²⁰ atoms/cm³.

Furthermore, the step of forming the passivating contact structure includes:
acid cleaning: subjecting the N-type substrate after diffusion treatment to acid cleaning using a first acid agent to remove silicon glass doped with the N-type conductive element and formed on the light-receiving surface and the back surface of the N-type substrate;
depositing the first dielectric layer, a front intrinsic layer, a front doped layer doped with the N-type conductive element, and a front mask layer in sequence on the N-type diffusion layer;
alkali polishing: removing the front mask layer wrapping the back surface using a second acid agent, then polishing the back surface of the N-type substrate using a first alkali agent, and removing the front doped layer, the front intrinsic layer, and the first dielectric layer that wrap the back surface and edges;
depositing the second dielectric layer, a back intrinsic layer, a back doped layer doped with the P-type conductive element, and a back mask layer in sequence on the back surface;
wherein the N-type conductive element includes at least one of a boron element, an indium element, or a gallium element, and the P-type conductive element includes at least one of a phosphorus element, a germanium element, or a selenium element.

Furthermore, the front doped layer includes a first front doped sublayer and a second front doped sublayer, each of the first front doped sublayer and the second front doped sublayer is doped with the N-type conductive element.

Furthermore, the back doped layer includes a first back doped sublayer and a second back doped sublayer, each of the first back doped sublayer and the second back doped sublayer is doped with the P-type conductive element.

The N-type conductive element is a phosphorus element, and the P-type conductive element includes is a boron element.

Furthermore, the step of patterning treatment includes:
printing: printing a patterned acid-resistant paste on the front mask layer, wherein a patterned region of the acid-resistant paste corresponds to the preset region, and drying to cure the acid-resistant paste;
cleaning: etching away the front mask layer not covered in the preset region of the light-receiving surface using a third acid agent, then etching away the acid-resistant paste and the front doped layer, the front intrinsic layer, and the first dielectric layer that are not covered in the preset region of the light-receiving surface using a second alkali agent, and removing the front mask layer and the back mask layer using a fourth acid agent.

Furthermore, in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

Furthermore, in the annealing step, annealing is conducted in an atmosphere with a volume ratio of nitrogen to oxygen in a range from 1:1 to 8:1 at a temperature of 850 °C to 1000 °C for 90 minutes to 150 minutes.

Furthermore, the post-treatment step includes: forming a silicon oxide layer as the first passivation layer and then depositing a silicon nitride layer and/or a silicon oxynitride layer as the first anti-reflection layer on the N-type diffusion layer and the patterned N-type doped polysilicon layer, so that the first passivation layer and the first anti-reflection layer form the first function layer;
forming an aluminum oxide layer as the second passivation layer and then depositing a silicon nitride layer and/or a silicon oxynitride layer as the second anti-reflection layer on the P-type heavily doped polysilicon layer, so that the second passivation layer and the second anti-reflection layer form the second function layer.

In a third aspect, embodiments of the present application provide a photovoltaic module, including the solar cell as described in the first aspect, or the solar cell prepared by the method as described in the second aspect.

Compared with the prior art, the present application has the following beneficial effects:

The present application provides a solar cell with a novel structure that has multiple structural characteristics, including a double-sided passivating contact structure, a PN junction structure formed across the entire back surface, a local passivating contact structure on the light-receiving surface, and an N-type diffusion layer as a front surface field formed on the light-receiving surface. The combined effects of these structural characteristics not only break the current photoelectric conversion efficiency bottleneck facing passivated contact solar cells, but also increase the photoelectric conversion efficiency of the solar cell to 25.8% or above. Moreover, the product reliability can be effectively enhanced when a PN junction structure is disposed on the back surface.

The improvement in photoelectric conversion efficiency is attributed to three main factors: First, a passivating-contact PN-junction structure is formed on the entire back surface of the solar cell, and the second dielectric layer is thicker than 2 nm, which enables the contact layer system to be decoupled from the light absorber, thereby suppressing high Auger recombination in the PN junction at the light-receiving surface. The second passivating contact structure on the back surface includes a second dielectric layer and a P-type heavily doped polysilicon layer, and the passivating-contact PN-junction structure is formed between the P-type heavily doped polysilicon layer and the N-type substrate. Second, the light-receiving surface of the solar cell has a patterned first passivating contact structure only disposed below the first electrode, thereby cooperating with the passivating-contact PN-junction structure on the back surface to address issues such as high Auger recombination and metal recombination caused by boron diffusion doping on the front light-receiving surface. Third, the dielectric layer on the light-receiving surface and the dielectric layer on the back surface have different thicknesses, and the P-type doped polysilicon layer on the back surface is a heavily doped layer. This structural characteristic allows the thinner first dielectric layer on the light-receiving surface to facilitate efficient electron transport via the quantum tunneling effect, while the thicker second dielectric layer on the back surface employs through-holes, extending therethrough, as carrier transport channels, which synergistically cooperates with the electron-repelling effect of the P-type heavily doped polysilicon layer to selectively enable the efficient transport of holes having a relative lager size through the through-holes. As a result, the double-sided passivating contact structure with a PN junction on the back surface not only can ensure excellent carrier transport and surface passivation, but also can aid in decoupling of the PN junction. Through the combined effects of these multiple structures, the photoelectric conversion efficiency of the solar cell can be improved.

Since the PN junction structure is located at the back surface, the solar cell should meet relatively high requirements for the product reliability, particularly for the surface passivation quality of the light-receiving surface of the N-type substrate. In the present application, disposing an N-type diffusion layer on the light-receiving surface of the N-type substrate achieves the purpose of adding a front surface field on the light-receiving surface. This front surface field not only can reduce the surface passivation requirements of the light-receiving surface but also can enhance the solar cell's stability against ultraviolet exposure and can reduce lateral series resistance. Consequently, the product reliability of the solar cell can be improved from multiple functional perspectives.

### BRIEF DESCRIPTION OF THE DRAWINGS

To illustrate the technical solutions of the embodiments of the present application more clearly, the drawings used in the embodiments will be described briefly. Apparently, the following described drawings are merely for some embodiments of the present application, and other drawings can be derived from these drawings by those of ordinary skill in the art without any creative effort.
FIG. 1 is a schematic structural view of a solar cell according to an embodiment of the present application.
FIG. 2 is an enlarged schematic view of the structure at position A in FIG. 1.
FIG. 3 is a flowchart of a method for preparing a solar cell according to Example 1.

Reference signs: 1: N-type substrate; 2: N-type diffusion layer; 3: first passivating contact structure; 31: first dielectric layer; 32: N-type doped polysilicon layer; 4: second passivating contact structure; 41: second dielectric layer; 411: through-hole; 42: P-type heavily doped polysilicon layer; 5: first function layer; 51: first passivation layer; 52: first anti-reflection layer; 6: second function layer; 61: second passivation layer; 62: second anti-reflection layer; 7: first electrode; 8: second electrode.

### DETAILED DESCRIPTION

The technical solutions of the embodiments of the present application will be described more clearly and comprehensively below in conjunction with the accompanying drawings for the embodiments of the present application. Apparently, the embodiments described herein are only part of, not all of the embodiments of the present application. Base on the embodiments of the present application, other embodiments obtained by those of ordinary skill in the art without creative efforts shall fall within the protection scope of the present application.

In the description of the present application, the orientation or position relationships indicated by the terms "upper", "lower", "left", "right", "front", "back", "top", "bottom", "inner", "outer", "central", "vertical", "horizontal", "transverse", "longitudinal", and the like are based on the orientation or position relationships shown in the accompanying drawings and are intended to facilitate the description of the present application and the embodiments, rather than indicating or implying that the apparatus or element referred to must have a particular orientation or be constructed and operated in a particular orientation.

Moreover, in addition to indicating orientation or position relationships, the aforementioned terms can also be used to express other meanings. For example, the term "upper" may, in certain contexts, be used to denote a type of attachment or connection relationship. The specific meanings of these terms in the present application can be understood based on specific circumstances by those of ordinary skills in the art.

In addition, the terms "install", "dispose", "provided with", "connect", and "join" should be interpreted in a broad sense. For example, they may refer to a fixed connection, a detachable connection, or an integral connection, may refer to a mechanical connection or an electrical connection, and may refer to a direct connection, an indirect connection via an intermediate medium, an internal communication between two devices, elements, or components. The specific meanings of these terms in the present application can be understood based on specific circumstances by those of ordinary skills in the art.

Terms "first" and "second" are primarily used for distinguishing different devices, elements, or components (which may be of the same or different types and structures), and are not intended to indicate or imply relative importance or quantity of the referenced devices, elements, or components. In the description of the embodiments of the present application, "a plurality" means two or more, unless otherwise specified.

The technical solutions of the present application will be described below in conjunction with embodiments and the accompanying drawings.

The passivated contact solar cell in related art is a type of passivated contact cell in which a boron-diffused emitter is formed on the light-receiving surface, and a tunneling layer and an N-type doped polysilicon layer are formed on the back surface. For the passivated contact solar cells suitable for large-scale industrial production, although they exhibit a good high-temperature resistance characteristic, their photoelectric conversion efficiency has hit a bottleneck and is difficult to break through, remaining at approximately 25.1%. This is primarily because the emitter on the light-receiving surface of the passivated contact solar cell needs to balance the influences of Auger recombination and current transmission losses.

Since the emitter on the light-receiving surface of the passivated contact solar cell is a boron-diffused emitter, when current transmission losses are reduced by lowering the boron diffusion sheet resistance on the light-receiving surface, Auger recombination losses on the light-receiving surface can be significantly increased. When current transmission losses are reduced by increasing metal gridlines to decrease the resistance, more sunlight can be blocked by the metal gridlines, preventing sunlight from being absorbed by the silicon wafer, which still hinder the improvement of photoelectric conversion efficiency. Thus, it is difficult for current passivated contact solar cells to simultaneously reduce current transmission losses and recombination losses, thereby limiting further improvement of the photoelectric conversion efficiency of the passivated contact solar cells.

A double-sided passivating contact structure combined with a back-surface PN junction can improve passivated contact solar cells, contributing to breaking the bottleneck in the photoelectric conversion efficiency of these cells. This structural improvement involves providing passivating contact structures on both the light-receiving surface and the back surface of the N-type substrate, and relocating the boron-diffused emitter originally located on the light-receiving surface to the back surface of the solar cell to form a back-surface PN junction. As a result, doping on the light-receiving surface can be decreased, and surface recombination can be reduced, while minimizing minority carrier transport losses. Moreover, current transmission capacity on the back surface can be enhanced by adding more electrode gridlines without concerns about shading issues caused by increased gridlines.

However, for the solar cells with a double-sided passivating contact structure and a back-surface PN junction, minority carriers are primarily generated on the light-receiving surface (i.e., the light-incident surface exposed to sunlight) of the N-type substrate, and these minority carriers must therefore diffuse through the N-type substrate to reach the back surface and then be collected by the PN junction on the back surface. This mechanism makes it challenging to achieve product reliability of such solar cells, primarily arising from the following three issues:

First, such cells impose high requirements on the surface passivation quality of the solar cells. In the solar cell whose PN junction is disposed on the back surface, photogenerated carriers are mainly generated on the light-receiving surface of the N-type substrate. If the surface passivation quality of the light-receiving surface is inadequate, the photogenerated carriers are prone to recombination and loss when passing through the film layers with poor passivation effects, thus failing to reach the PN junction on the back surface of the N-type substrate. Finding materials with very high surface passivation quality is challenging, as the selection range is very limited, which is unfavorable for the large-scale production of solar cells.

Second, the ultraviolet stability is poor. Since the PN junction is disposed on the back surface, when the film layer with a passivating function is disposed on the light-receiving surface of the N-type substrate, it is difficult to achieve a balance between ultraviolet resistance and potential induced degradation (PID) resistance. Particularly for solar cells using a silicon oxide layer as the passivation layer on the light-receiving surface, significant performance degradation occurs when exposure to ultraviolet light. Specifically, upon ultraviolet exposure, the surface saturation current density (Joe) rises from 48 fA/cm² to 446 fA/cm². Ultraviolet exposure and light injection experiments reveal that when the ultraviolet energy exceeds 3.1 eV (corresponding to light with a wavelength less than 400 nm), the interface state density at the silicon oxide passivating surface increases significantly, leading to an increase in the surface recombination velocity (S_{front}).

Third, the lateral series resistance is high. Since the PN junction in the double-side passivating contact structure is disposed on the back surface, an N-type doped polysilicon layer containing a positively charged N-type conductive element such as phosphorus is disposed on the light-receiving surface. However, the doping concentration of the N-type conductive element in this N-type doped polysilicon layer is limited, resulting in a high sheet resistance that impedes the lateral movement of carriers and increases the lateral series resistance.

Based on the above analysis, the applicant believes that, in order to ensure product reliability while improving the photoelectric conversion efficiency of passivated contact solar cells, making the improved passivated contact solar cells have more reliable and stable product characteristics to adapt to large-scale production, there is a need to further modify the structures of such solar cells, which can not only break through the current photoelectric conversion efficiency bottleneck of existing passivated contact solar cells but also exhibit excellent product reliability.

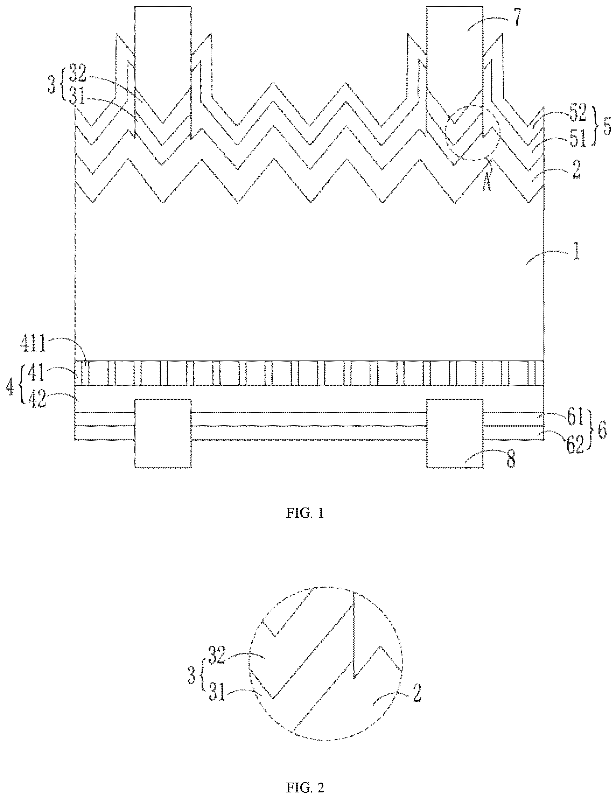

In a first aspect, embodiments of the present application provide a solar cell. As shown in FIG. 1, which is a schematic structural view of a solar cell according to an embodiment of the present application, the solar cell includes:
an N-type substrate 1;
an N-type diffusion layer 2 disposed on a light-receiving surface of the N-type substrate 1;
a patterned first passivating contact structure 3 disposed on the N-type diffusion layer 2, wherein the first passivating contact structure 3 includes a first dielectric layer 31 disposed adjacent to the N-type diffusion layer 2 and an N-type doped polysilicon layer 32 disposed away from the N-type diffusion layer 2, and a thickness of the first dielectric layer 31 is less than or equal to 2 nm;
a second passivating contact structure 4 disposed on an entirety of a back surface of the N-type substrate 1, wherein the second passivating contact structure includes a second dielectric layer 41 disposed adjacent to the N-type substrate 1 and a P-type heavily doped polysilicon layer 42 disposed away from the N-type substrate 1, and a PN junction is formed between the P-type heavily doped polysilicon layer 42 and the N-type substrate 1, wherein a thickness of the second dielectric layer 41 is greater than 2 nm, the second dielectric layer has a through-hole 411 that communicates the N-type substrate 1 with the P-type heavily doped polysilicon layer 42, and a doping concentration of a P-type conductive element in the P-type heavily doped polysilicon layer 42 is in a range from 5×10¹⁸ atoms/cm³ to 3×10²⁰ atoms/cm³;
a first function layer 5 disposed on surfaces of the N-type diffusion layer 2 and the N-type doped polysilicon layer 32 away from the substrate;
a second function layer disposed on a surface of the P-type heavily doped polysilicon layer 42 away from the N-type substrate 1;
a first electrode 7 extending through the first function layer 5 and forming an ohmic contact with the N-type doped polysilicon layer 32, wherein a patterned region of the first passivating contact structure 3 is disposed corresponding to a patterned region of the first electrode 7;
a second electrode 8 extending through the second function layer and forming an ohmic contact with the P-type heavily doped polysilicon layer 42.

The materials of the first dielectric layer and the second dielectric layer can include various dielectric materials, such as at least one of silicon oxide, magnesium fluoride, amorphous silicon, polycrystalline silicon, silicon carbide, silicon nitride, silicon oxynitride, aluminum oxide, or titanium oxide. Specifically, the dielectric layer may be composed of a silicon oxide layer containing silicon oxide. The silicon oxide layer has excellent passivation performance, which can minimize the recombination losses of minority carriers on the surface of the semiconductor substrate, and the silicon oxide layer is a film with excellent durability for subsequent high-temperature processes.

The thickness of the first dielectric layer 31 is less than or equal to 2 nm, preferably less than or equal to 1.5 nm. Under such a thin thickness condition, electrons as carriers generated by light irradiation on the light-receiving surface can pass through the first dielectric layer 31 via a tunneling mechanism, achieving electron collection. It can be understood that the first dielectric layer 31 of this thickness can break and form some micro holes due to annealing operations during the manufacturing process. These micro holes can serve as electron transport channels, allowing electrons to be transported through both tunneling and direct conduction mechanisms to conduct electricity. The thickness of the first dielectric layer 31 is in a range from 0.8 nm to 2.0 nm, including any point value within this range. For example, the thickness of the first dielectric layer 31 can be 0.8 nm, 0.9 nm, 1.0 nm, 1.2 nm, 1.5 nm, 1.6 nm, 1.8 nm, or 2.0 nm. Furthermore, the first dielectric layer 31 can also function as a diffusion barrier to prevent the dopant of the N-type doped polysilicon layer from diffusing into the semiconductor substrate, wherein the dopant of the N-type doped polysilicon layer refers to the N-type conductive element doped into the N-type doped polysilicon layer.

The thickness of the second dielectric layer 41 is greater than 2 nm. At this thickness, electrons can hardly pass through the film layer via a tunneling mechanism. A hole, which is larger in volume than an electron, is even less likely to pass through the film layer via a tunneling mechanism. Accordingly, in the present application, through-holes 411 are formed in and extend through the second dielectric layer 41 along the thickness direction of the second dielectric layer 41, in combination with a P-type heavily doped polysilicon layer, enabling hole transport on the back surface. Furthermore, the second dielectric layer 41 can also function as a diffusion barrier to prevent the dopant of the P-type doped polysilicon layer from diffusing into the semiconductor substrate, wherein the dopant of the P-type doped polysilicon layer refers to the P-type conductive element doped in the P-type doped polysilicon layer.

The doping concentration of the P-type conductive element in the P-type heavily doped polysilicon layer is in a range from 5×10¹⁸ atoms/cm³ to 3×10²⁰ atoms/cm³. Within this doping concentration range, the doping concentration of the P-type conductive element in the P-type heavily doped polysilicon layer is relatively high, which qualifies as heavy doping. It can be found in the present application that when a relatively thick second dielectric layer with a thickness greater than 2 nm is disposed on the back surface, it can cooperate with the P-type heavily doped polysilicon layer at the above doping concentration to achieve excellent selection for holes, effectively addressing the issue that an electron with a small volume always has a higher passing-through probability than a hole with a large volume. The doping concentration includes any point value within the numerical range, for example, the doping concentration of the P-type conductive element in the P-type heavily doped polysilicon layer can be 5×10¹⁸ atoms/cm³, 6×10¹⁸ atoms/cm³, 8×10¹⁸ atoms/cm³, 1×10¹⁹ atoms/cm³, 5×10¹⁹ atoms/cm³, 8×10¹⁹ atoms/cm³, 1×10²⁰ atoms/cm³, or 3×10²⁰ atoms/cm³.

The entire coverage with the second passivating contact structure 4 refers to that: unlike the patterned first passivating contact structure 3, the second passivating contact structure 4 covers the back surface of the N-type substrate 1, thereby forming a substantially complete film layer structure rather than a patterned structure for local passivation.

The patterned region of the first passivating contact structure is disposed corresponding to the patterned region of the first electrode, meaning that the patterned region of the first passivating contact structure and the patterned region of the first electrode correspond in position, with the same or similar width dimensions. For example, the widths of both patterns can be identical, or the width of the first passivating contact structure can be slightly greater than that of the first electrode, thereby ensuring that the first electrode, which is primarily made of metal, can be only in contact with the first passivating contact structure and cannot be in contact with the silicon wafer, while also ensuring the alignment effect between the first electrode and the first passivating contact structure.

The embodiments of the present application provide a solar cell with a novel structure that has multiple structural characteristics, including a double-sided passivating contact structure, a PN junction structure formed across the entire back surface, a local passivating contact structure on the light-receiving surface, and an N-type diffusion layer 2 formed on the light-receiving surface. The combined effects of these structural characteristics not only break the current photoelectric conversion efficiency bottleneck facing passivated contact solar cells, but also increase the photoelectric conversion efficiency of the solar cell to 25.8% or above. Moreover, the product reliability can be effectively enhanced when a PN junction structure is disposed on the back surface.

The structural characteristics and performance advantages of the solar cell are described in detail below.

In terms of photoelectric conversion efficiency, the solar cell in the embodiments of the present application has a double-sided passivating contact structure that combines a local passivating contact on the light-receiving surface with a passivating contact on the entire back surface and has a decoupled PN junction on the back surface, so that the solar cell can simultaneously have relatively low recombination losses and current transmission losses on the light-receiving surface, enabling the photoelectric conversion efficiency of the solar cell to be equal to or greater than 25.8%.

First, the solar cell of the embodiments of the present application has a passivating-contact PN junction structure on the entire back surface. The solar cell of the embodiments of the present application has a first passivating contact structure 3 and a second passivating contact structure 4 on the light-receiving surface and the back surface of the N-type substrate 1, respectively. Furthermore, the second passivating contact structure 4 on the back surface includes a P-type heavily doped polysilicon layer 42, which not only achieves the passivating contact function with the second dielectric layer 41 but also forms a PN junction relative to the N-type substrate 1, thereby simultaneously forming a passivating contact structure and a PN junction structure, i.e., a passivating-contact PN junction structure, on the back surface of the solar cell. In this way, the passivating-contact PN junction structure can decouple the contact layer system from the light absorber, unlike the prior art, in which the boron-diffused PN junction is formed adjacent to the light-receiving surface of the N-type substrate 1. Thus, the passivating-contact PN junction structure can effectively address the high Auger recombination issue in the light-receiving surface PN junction, thereby avoiding the contradiction between boron diffusion sheet resistance and Auger recombination losses in the light-receiving surface PN junction. It should be noted that when a tunneling layer and an N-type doped polysilicon layer 32 (e.g., a polysilicon layer doped with phosphorus) are formed on the back surface of the N-type substrate 1 in related art, the tunneling layer and the N-type doped polysilicon layer 32 can form a passivating contact structure. Nevertheless, strong electronic and chemical interactions still occur between this structure and the N-type substrate 1, leading to band bending and diffusion. Consequently, the doped polysilicon layer in this structure is not decoupled from the N-type substrate 1, and remains strongly associated with the N-type substrate 1.

In addition to the advantage of decoupling, in the present application, since the passivating-contact PN junction structure is formed on the back surface, no shading occurs. Thus, the current transmission losses can be further reduced by increasing the number of metal gridlines on the back surface. Compared with forming the PN junction on the light-receiving surface, which requires considering various limitations such as the number and area of metal gridlines, in the embodiments of the present application, the passivating-contact PN junction structure is formed on the back surface, which not only has the advantage in reducing Auger recombination losses but also has the advantage of further reducing current transmission losses without affecting light absorption. That is, by disposing the passivating-contact PN junction structure on the back surface in the embodiments of this application, the Auger recombination losses and current transmission losses can be reduced simultaneously, thereby further improving the photoelectric conversion efficiency of the solar cell.

Second, while the passivating-contact PN junction structure is formed on the back surface of the solar cell, a local passivating contact structure is formed on the light-receiving surface of the solar cell of the embodiments of the present application. The first passivating contact structure 3 formed on the light-receiving surface is only located corresponding to the metallized region. That is, the first dielectric layer 31 and the N-type doped polysilicon layer 32 are disposed under the first electrode 7. Forming a local passivating contact structure on the light-receiving surface overcomes the high Auger recombination issue caused by boron diffusion doping, especially heavy doping, across the entire light-receiving surface, and reduces the metal-induced recombination caused by metallization on the light-receiving surface in related art. Moreover, since the light-receiving surface employs a local passivating contact structure, parasitic absorption and decrease in the cell's short-circuit current that are caused by the N-type doped polysilicon layer 32 in the first passivating contact structure 3 can be effectively alleviated, thereby increasing the short-circuit current performance and improving the photoelectric conversion efficiency of the solar cell.

As such, since a local passivating contact structure is formed on the light-receiving surface of the solar cell, the cell performance can be improved by reducing recombination losses and back surface resistance, thereby improving the photoelectric conversion efficiency of the solar cell. The passivating-contact PN junction structure is formed on the entire back surface of the solar cell, which not only can reduce the recombination losses on the light-receiving surface, but also can conduct electric current across the entire N-type substrate 1, thereby reducing minority carrier transport losses at the front local metal contacts and improving the fill factor, further improving the photoelectric conversion efficiency of the solar cell.

Finally, and particularly importantly, based on disposing the PN junction on the back surface, the solar cell according to the embodiments of the present application can effectively collect carriers from the light-receiving surface and the back surface through the synergistic effects of the double-sided passivating contact structure having different dielectric layer thicknesses and the P-type heavily doped polysilicon layer 42 on the back surface. Specifically, in the solar cell according to the embodiments of the present application, the PN junction is disposed on the back surface, the carriers to be collected from the back surface are holes, while the carriers to be collected from the light-receiving surface are electrons. The volume of a hole is much larger than that of an electron, and via the quantum tunneling effect, the tunneling probability of electrons is always greater than that of holes. Therefore, effective transport of holes from the back surface cannot be realized by the conventional quantum tunneling mechanism. To this end, in the present application, on the light-receiving surface, a combination structure of a thinner first dielectric layer 31 and an N-type doped polysilicon layer 32 is adopted. The thickness of the first dielectric layer 31 is less than or equal to 2 nm. Under this thickness condition, the first dielectric layer 31 can allow electrons, which are relatively small, to tunnel through the film structure of the first dielectric layer 31, and can also adopt micro holes in the first dielectric layer 31 as conductive channels to complete the transport of electrons as carriers. On the back surface, a combination structure of a thicker second dielectric layer 41 and a P-type heavily doped polysilicon layer 42 is adopted. The thickness of the second dielectric layer 41 is greater than 2 nm, which is beyond the ideal tunneling layer thickness, and the holes are relatively large, making it difficult to selectively transport holes via the tunneling mechanism. In the present application, through-holes 411 are formed in and extend through the thicker second dielectric layer 41, and a P-type heavily doped polysilicon layer 42 is employed. Through the synergistic effect of the two, the electron-repelling effect of the P-type heavily doped polysilicon layer 42 is used for blocking electrons while selectively allowing holes to undergo carrier transport via the through-holes 411, completing the transport of holes as carriers.

In view of the foregoing, the solar cell according to the embodiments of the present application can further improve the photoelectric conversion efficiency of the solar cell through the cooperation of the above structures.

In terms of product reliability, disposing the PN junction structure on the back surface requires that a large number of holes as carriers can reach the back surface for collection, and consequently there is a high requirement on the surface passivation quality of the light-receiving surface of the N-type substrate 1 to ensure product reliability. In the solar cell according to the embodiment of the present application, the N-type diffusion layer 2 is disposed between the N-type substrate 1 and the first dielectric layer 31 on the light-receiving surface. That is, on the basis of disposing the PN junction structure on the back surface, a front surface field is additionally formed on the light-receiving surface.

On the one hand, the back-junction structure with the N-type diffusion layer 2 on the light-receiving surface can maintain high efficiency at a wide range of front surface recombination velocity (S₀, _{front}) (<500 cm/s). This property can reduce the surface passivation requirements of the light-receiving surface by incorporating the N-type diffusion layer. Even using conventional passivation materials, surface recombination can be suppressed, facilitating the selection of passivation materials in mass production. On the other hand, additionally forming the N-type diffusion layer 2 on the light-receiving surface allows the solar cell according to the embodiments of the present application to have good stability under ultraviolet exposure. The doped region of the N-type diffusion layer 2 can lower the minority carrier density and thereby can decrease surface recombination. Furthermore, the N-type diffusion layer 2 can repel minority carriers on the light-receiving surface and reduce surface recombination. Additionally, the doped region of the N-type diffusion layer 2 can serve as a parallel low-resistance path that allows majority carriers on the light-receiving surface to reach the metal contacts, thereby helping to reduce lateral series resistance.

The specific structure of the solar cell according to the embodiments of the present application is further explained below.

**The N-type substrate 1** can be, for example, an N-type silicon wafer. The light-receiving surface of the N-type silicon wafer serves as the light-incident surface, receiving sunlight to generate carriers in the form of electrons and holes.

**The N-type diffusion layer 2** is disposed on the light-receiving surface of the N-type substrate 1, and can be a phosphorus diffusion layer, a germanium diffusion layer, a selenium diffusion layer, or the like, which is formed by doping an N-type conductive element into the N-type substrate 1. Preferably, the N-type diffusion layer 2 is the phosphorus diffusion layer, a sheet resistance of the N-type diffusion layer 2 is in a range from 200 Ω/sq to 350 Ω/sq, a thickness of the N-type diffusion layer 2 is in a range from 0.05 µm to 0.5 µm, and a doping concentration of the N-type conductive element in the N-type diffusion layer 2 is in a range from 5×10¹⁸ atoms/cm³ to 1×10²⁰ atoms/cm³. Using such a phosphorus diffusion layer as a diffusion layer adjacent to the N-type substrate 1 can reduce intrinsic recombination, Shockley-Read-Hall (SRH) recombination, and electron bulk resistance losses. This is because the enhanced internal electric field promotes the separation of electrons and holes, shortens carrier transport time, and ultimately suppresses overall bulk recombination. Particularly when the sheet resistance of the N-type diffusion layer 2 is within the aforementioned range, the recombination in the N-type diffusion layer 2 remains relatively low, which is conducive to further suppressing the overall bulk recombination.

The sheet resistance of the N-type diffusion layer 2 in the range from 200 Ω/sq to 350 Ω/sq can be any value within this range, such as 200 Ω/sq, 210 Ω/sq, 220 Ω/sq, 230 Ω/sq, 240 Ω/sq, 250 Ω/sq, 260 Ω/sq, 270 Ω/sq, 280 Ω/sq, 290 Ω/sq, or 300 Ω/sq. The thickness of the N-type diffusion layer 2 in the range from 0.05 µm to 0.5 µm can be any value within this range, such as 0.05 µm, 0.08 µm, 0.1 µm, 0.15 µm, 0.2 µm, 0.3 µm, 0.4 µm, or 0.5 µm. The doping concentration of the N-type conductive element in the N-type diffusion layer 2 in the range from 5×10¹⁸ atoms/cm³ to 1×10²⁰ atoms/cm³ can be any value within this range, such as 5×10¹⁸ atoms/cm³, 1×10¹⁹ atoms/cm³, 2×10¹⁹ atoms/cm³, 4×10¹⁹ atoms/cm³, 5×10¹⁹ atoms/cm³, 8×10¹⁹ atoms/cm³, or 1×10²⁰ atoms/cm³.

Further referring to FIG. 2, which is an enlarged schematic view of the structure at point A in FIG. 1, the thickness of the N-type diffusion layer 2 varies in different regions. The N-type diffusion layer 2 covered by the first passivating contact structure 3 can be 0.05 µm to 0.15 µm thicker than the N-type diffusion layer 2 not covered by the first passivating contact structure 3. That is, in the region not covered by the first passivating contact structure 3, the N-type diffusion layer 2 is relatively slightly thinner. This structural arrangement ensures that when preparing the patterned first passivating contact structure 3, the region where the first passivating contact structure 3 does not need to be retained can be fully etched away, preventing residues of the first passivating contact structure 3 on the N-type diffusion layer 2 from absorbing light and affecting the photoelectric conversion efficiency, thereby ensuring the patterning effect of the first passivating contact structure 3.

**The patterned first passivating contact structure 3** is disposed on the N-type diffusion layer 2 and is only disposed under the position corresponding to the first electrode 7, achieving local passivating contact on the light-receiving surface. The width of the first passivating contact structure 3 can be in a range from 20 µm to 110 µm, which is slightly wider than the width of the first electrode 7, ensuring good ohmic contact between the first electrode 7 and the first passivating contact structure 3. Within this width range, the first passivating contact structure 3 can provide certain carrier transport and passivation effects, and can reduce the doping amount on the light-receiving surface of the substrate by limiting the doping on the front surface to doping a gridline pattern, thereby better suppressing the Auger recombination caused by doping diffusion. It should be understood that the widths of both the first dielectric layer 31 and the N-type doped polysilicon layer 32 in the first passivating contact structure 3 fall within the above width range.

In the first passivating contact structure 3, the thickness of the N-type doped polysilicon layer 32 can be in a range from 30 nm to 200 nm. The N-type conductive element doped in the N-type doped polysilicon layer 32 includes at least one of element phosphorus, element germanium, or element selenium, preferably element phosphorus. The thickness of the N-type doped polysilicon layer 32 in the range from 30 nm to 200 nm can be any point value within this range, for example, the thickness of the N-type doped polysilicon layer 32 can be 30 nm, 50 nm, 80 nm, 100 nm, 120 nm, 150 nm, 180 nm, or 200 nm.

**The second passivating contact structure 4** is disposed on the back surface of the N-type substrate 1, which is not a patterned passivating contact structure but a passivating contact structure for entire surface coverage. The structure in the second passivating contact structure 4 used for carrier transport is the second dielectric layer 41. The second dielectric layer 41 has through-holes 411 extending therethrough, which can cooperate with the P-type heavily doped polysilicon layer 42, so that the through-holes 411 can selectively allow holes to pass through and block electrons.

The diameter of the through-hole 411 in the second dielectric layer 41 can be in a range from 50 nm to 500 nm, and the number of the through-holes can be in a range from 1×10⁴/cm² to 1.6×10⁸/cm². Through-holes 411 within the above diameter and quantity ranges are favorable for better controlling the passivation effect and direct carrier conduction transport effect of the second dielectric layer 41, achieving good direct carrier transport while maintaining good passivation, reducing the adversely effect on passivation caused by too many or too large through-holes 411, and avoiding the hindrance to direct hole transport caused by too few or too small through-holes 411. The diameter of the through-hole 411 can be in a range from 50 nm to 500 nm, including any point value within this diameter range. For example, the diameter of the through-hole 411 can be 50 nm, 80 nm, 100 nm, 150 nm, 200 nm, 250 nm, 300 nm, 350 nm, 400 nm, 450 nm, or 500 nm. The number of through-holes 411 can be in a range from 1×10⁴ /cm² to 1.6×10⁸ /cm², including any point value within this number range. For example, the number of through-hole 411 can be 1×10⁴/cm², 2×10⁴/cm², 5×10⁴/cm², 8×10⁴/cm², 1×10⁵/cm², 2×10⁵/cm², 5×10⁵/cm², 8×10⁵/cm², or 1×10⁶/cm².

In the second passivating contact structure 4, the thickness of the P-type heavily doped polysilicon layer 42 can be in a range from 200 nm to 400 nm. The P-type conductive element doped in the P-type heavily doped polysilicon layer 42 includes at least one of element boron, element indium, or element gallium, preferably element boron. The thickness of the P-type heavily doped polysilicon layer 42 in the range from 200 nm to 400 nm can be any point value within this range. For example, the thickness of the P-type heavily doped polysilicon layer 42 can be 200 nm, 250 nm, 300 nm, 350 nm, or 400 nm.

In the double-sided passivating contact structure of the present application, the P-type doped polysilicon layer on the back surface is thicker than the N-type doped polysilicon layer 32 on the light-receiving surface, to achieve the same or similar sheet resistance. Taking the N-type doped polysilicon layer 32 doped with element phosphorus on the light-receiving surface and the P-type heavily doped polysilicon layer 42 doped with element boron on the back surface as an example, the solid solubility of element phosphorus in the N-type doped polysilicon layer 32 is much higher than that of element boron in the P-type heavily doped polysilicon layer 42. Therefore, the thicker P-type doped polysilicon layer facilitates doping more element boron, enabling the sheet resistance of the back surface and the light-receiving surface to reach the same or similar levels.

**The first function layer 5** is disposed on the N-type diffusion layer 2 and the first passivating contact structure 3. Specifically, since the first passivating contact structure 3 is a local passivating contact structure, in the region where the first electrode 7 is not disposed, the first function layer 5 is disposed on the N-type diffusion layer 2. In the region where the first electrode 7 is disposed, the first function layer 5 is disposed on the N-type doped polysilicon layer 32 of the first passivating contact structure 3, and the first electrode 7 extends through the first function layer 5 and forms an ohmic contact with the N-type doped polysilicon layer 32. The first function layer 5 can be only the first passivation layer 51, or only the first anti-reflection layer 52, or the first function layer 5 can include the first passivation layer 51 disposed adjacent to the N-type diffusion layer 2 and the first anti-reflection layer 52 disposed away from the N-type diffusion layer 2. The thickness of the first passivation layer 51 can be in a range from 3 nm to 5 nm, for example, 3 nm, 4 nm, or 5 nm. The thickness of the first anti-reflection layer 52 can be in a range from 75 nm to 85 nm, for example, 75 nm, 78 nm, 80 nm, 82 nm, or 85 nm. The refractive index of the first anti-reflection layer 52 can be in a range from 1.95 to 2.00. The first passivation layer 51 can be a single layer or a composite of multiple sub-layers. The first passivation layer 51 preferably is a silicon oxide layer. The first anti-reflection layer 52 can be a single layer or a composite of multiple sub-layers. For example, the first anti-reflection layer 52 can be a single silicon nitride layer, or can be formed by compositing multiple silicon nitride layers. Preferably, the first anti-reflection layer 52 is composed of a silicon nitride layer, a silicon oxynitride layer, and a silicon oxide layer disposed sequentially from the inside to outside, i.e., from the direction adjacent to the substrate to the direction away from the substrate.

Different from the passivation layer made of aluminum oxide, in an embodiment of the present application, the first passivation layer 51 on the light-receiving surface is made of a silicon oxide material. The passivation layer made of the silicon oxide material has better PID resistance but inferior ultraviolet resistance. Nevertheless, because the N-type diffusion layer 2 is disposed on the light-receiving surface of the solar according to the embodiment of the present application, under the action of the N-type diffusion layer 2, the ultraviolet resistance of the silicon oxide passivation layer serving as the first passivation layer 51 can be improved and surface recombination can be reduced. Therefore, through the combined effect of the N-type diffusion layer 2 and the silicon oxide layer as the first passivation layer 51, the solar cell can achieve improved PID resistance and good ultraviolet stability.

**The second function layer 6** is disposed on the surface, which is away from the N-type substrate 1, of the P-type heavily doped polysilicon layer 42 on the back surface. The second electrode 8 extends through the second function layer 6 and forms an ohmic contact with the P-type heavily doped polysilicon layer 42. The second function layer 6 can be only the second passivation layer 61, or only the second anti-reflection layer 62, or the second function layer 6 can include the second passivation layer 61 disposed adjacent to the P-type heavily doped polysilicon layer 42 and the second anti-reflection layer 62 disposed away from the P-type heavily doped polysilicon layer 42. Preferably, the second function layer 6 includes the second passivation layer 61 disposed adjacent to the P-type heavily doped polysilicon layer 42 and the second anti-reflection layer 62 disposed away from the P-type heavily doped polysilicon layer 42. The thickness of the second passivation layer 61 can be in a range from 3 nm to 5 nm, for example, 3 nm, 4 nm, or 5 nm. The thickness of the second anti-reflection layer 62 can be in a range from 75 nm to 80 nm, for example, 75 nm, 76 nm, 77 nm, 78 nm, 79 nm, or 80 nm. The refractive index of the second anti-reflection layer 62 can be in a range from 2.10 to 2.15. The second passivation layer 61 can be a single layer or a composite of multiple sub-layers. For example, the second passivation layer 61 can be an aluminum oxide layer or can be obtained by compositing multiple aluminum oxide sub-layers. Disposing the second passivation layer 61 on the back surface side of the N-type substrate 1 can passivate and protect the PN junction located on the back surface. The second anti-reflection layer 62 can be a single layer or a composite of multiple sub-layers. For example, the second anti-reflection layer 62 can be a single silicon nitride layer or can be obtained by compositing multiple silicon nitride layers.

**The first electrode 7** extends through the first function layer 5 and then forms an ohmic contact with the N-type doped polysilicon layer 32. The width of the first electrode 7 is equal to or slightly smaller than the width of the N-type doped polysilicon layer 32, ensuring a good and reliable ohmic connection between the first electrode 7 and the N-type doped polysilicon layer 32. When the first function layer 5 includes several different film layer structures, for example, when the first function layer 5 includes the first passivation layer 51 and the first anti-reflection layer 52 that are disposed from inside to outside, the first electrode 7 sequentially extends through the first anti-reflection layer 52 and the first passivation layer 51 and then form an ohmic contact with the N-type doped polysilicon layer 32. The second electrode 8 extends through the second function layer 6 and then forms an ohmic contact with the P-type heavily doped polysilicon layer 42. When the second function layer 6 includes several different film layer structures, for example, when the second function layer 6 includes the second passivation layer 61 and the second anti-reflection layer 62 that are disposed from inside to outside, the second electrode 8 sequentially extends through the second anti-reflection layer 62 and the second passivation layer 61 and then form an ohmic contact with the P-type heavily doped polysilicon layer 42.

In addition, since the PN junction in the embodiments of the present application is formed on the back surface side, more electrode gridlines can be disposed on this back surface side. The ratio of the quantity of the gridlines of the second electrode 8 to the quantity of the gridlines of the first electrode 7 can be in a range from 1.2:1 to 1.6:1. In this way, increasing the number of the gridlines on the back surface can further enhance current transmission capability without causing shading issues, thereby further improving the photoelectric conversion efficiency of the solar cell.

In a second aspect, embodiments of the present application provide a method for preparing the solar cell as described in the first aspect, including the following steps:
forming the N-type diffusion layer: diffusing the N-type conductive element on the light-receiving surface of the N-type substrate to obtain the N-type diffusion layer;
forming the passivating contact structure: forming the first dielectric layer and an N-type doped amorphous silicon layer in sequence on a surface of the N-type diffusion layer away from the N-type substrate, and forming the second dielectric layer and a P-type doped amorphous silicon layer in sequence on the back surface of the N-type substrate;
patterning treatment: printing a patterned paste in a preset region of the N-type doped amorphous silicon layer, then performing etching and cleaning to remove the first dielectric layer and the N-type doped amorphous silicon layer not covered in the preset region, and then removing the paste to retain the first dielectric layer and the N-type doped amorphous silicon layer covered in the preset region;
annealing: annealing the N-type substrate after the patterning treatment to convert the N-type doped amorphous silicon layer into the N-type doped polysilicon layer and to convert the P-type doped amorphous silicon layer into the P-type heavily doped polysilicon layer, wherein the first dielectric layer and the N-type doped polysilicon layer form the first passivating contact structure, the second dielectric layer and the P-type heavily doped polysilicon layer form the second passivating contact structure, and the PN junction is formed between the N-type substrate and the P-type heavily doped polysilicon layer;
post-treatment: forming the first function layer on the N-type diffusion layer and the patterned N-type doped polysilicon layer, forming the second function layer on the P-type heavily doped polysilicon layer, forming the first electrode on the first function layer and allowing the first electrode to extend through the first function layer and form the ohmic contact with the N-type doped polysilicon layer, and forming the second electrode on the second function layer and allowing the second electrode to extend through the second function layer and form the ohmic contact with the P-type heavily doped polysilicon layer.

The steps will be further described blow.

The step of forming the N-type diffusion layer includes: performing drive-in diffusion of the N-type conductive element on the light-receiving surface of the N-type substrate using nitrogen gas carrying oxygen and a gas source containing the N-type conductive element, thereby forming the N-type diffusion layer with a thickness in a range from 0.05 µm to 0.5 µm, wherein a sheet resistance of the N-type diffusion layer is in a range from 200 Ω/sq to 350 Ω/sq, and a doping concentration of the N-type conductive element in the N-type diffusion layer is in a range from 5×10¹⁸ atoms/cm³ to 1×10²⁰ atoms/cm³.

As an optional embodiment, the N-type conductive element in the above step is element phosphorus, and the gas source containing the N-type conductive element is phosphorus oxychloride.

The N-type diffusion layer is formed on the surface of the N-type substrate as a front surface field through the drive-in diffusion process. This process exhibits strong compatibility with existing processes, facilitating industrial application.

**Forming the passivating contact structure** includes following steps:
acid cleaning: subjecting the N-type substrate after diffusion treatment to acid cleaning using a first acid agent to remove silicon glass doped with the N-type conductive element and formed on the light-receiving surface and the back surface of the N-type substrate;
depositing the first dielectric layer, a front intrinsic layer, a front doped layer doped with the N-type conductive element, and a front mask layer in sequence on the N-type diffusion layer;
alkali polishing: removing the front mask layer wrapping the back surface using a second acid agent, then polishing the back surface of the N-type substrate using a first alkali agent, and removing the front doped layer, the front intrinsic layer, and the first dielectric layer that wrap the back surface and edges;
depositing the second dielectric layer, a back intrinsic layer, a back doped layer doped with the P-type conductive element, and a back mask layer in sequence on the back surface;
wherein the N-type conductive element includes at least one of element boron, element indium, or element gallium, and the P-type conductive element includes at least one of element phosphorus, element germanium, or element selenium.

In the steps of forming the passivating contact structure, the first acid agent used for acid cleaning can be a hydrofluoric acid solution with a volume percentage in a range from 4% to 6%. Taking the N-type diffusion layer being a phosphorus diffusion layer as an example, the phosphosilicate glass formed on the light-receiving surface and the back surface during the formation of the N-type diffusion layer can be removed using the first acid agent. In the alkali polishing step, the second acid agent can be a hydrofluoric acid solution with a volume percentage in a range from 4% to 6%, and the first alkali agent can be a mixture of alkali metal hydroxide and an alkali polishing additive in a volume ratio ranging from 2:1 to 4:1. The temperature for alkali polishing is in a range from 70 °C to 90 °C, and the texturing time lasts 5 minutes (min) to 8 min. Using the reagents to treat the doped silicon glass formed during the formation of the N-type diffusion layer and the wrap-around coating formed during the preparation of the double-sided passivating contact structure can better achieve effects such as polishing and wrap-around removal.

Furthermore, the front doped layer can be a single layer or multiple layers. For example, the front doped layer includes a first front doped sublayer and a second front doped sublayer, each of the first front doped sublayer and the second front doped sublayer is doped with the N-type conductive element. Preferably, the N-type conductive element is element phosphorus. Compared with disposing only a single layer of the front doped layer, dividing the front doped layer into two or more layers allows for reducing the doping concentration of the N-type conductive element in each layer while ensuring the total doping concentration reaches a certain level, thereby lowering the probability of lattice distortion caused by high doping concentrations. Similarly, the back doped layer can be a single layer or multiple layers. For example, the back doped layer includes a first back doped sublayer and a second back doped sublayer, and each of the first back doped sublayer and the second back doped sublayer is doped with the P-type conductive element. Preferably, the P-type conductive element is element boron. When the back doped layer is structured in multiple layers, it achieves effects similar to those of the front doped layer in multiple layers.

The processes for depositing the first dielectric layer, the N-type doped amorphous silicon layer, the second dielectric layer, and the P-type doped amorphous silicon layer can be plasma enhanced chemical vapor deposition (PECVD), low pressure chemical vapor deposition (LPCVD), atomic layer deposition (ALD), or the like. Preferably, the above film layers can be deposited by PECVD.

**The patterning treatment** includes following steps:
printing: printing a patterned acid-resistant paste on the front mask layer, wherein a patterned region of the acid-resistant paste corresponds to the preset region, and drying to cure the acid-resistant paste;
cleaning: etching away the front mask layer not covered in the preset region of the light-receiving surface using a third acid agent, then etching away the acid-resistant paste and the front doped layer, the front intrinsic layer, and the first dielectric layer that are not covered in the preset region of the light-receiving surface using a second alkali agent, and removing the front mask layer and the back mask layer using a fourth acid agent.

Furthermore, in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds. In the cleaning step, the third acid agent can be a hydrofluoric acid solution with a mass percentage ranging from 4% to 6%, and the first alkali agent can be a mixture of alkali metal hydroxide and a texturing additive in a volume ratio ranging from 1:1 to 3:1. The cleaning temperature is in a range from 70 °C to 90 °C, and the texturing time lasts 1 min to 3 min.

In the step of patterning treatment, the patterned acid-resistant paste is printed in the preset region on the front mask layer on the light-receiving surface and then the patterned acid-resistant paste is cured. The acid-resistant paste can protect the first doped amorphous silicon layer and the tunneling layer in the preset region by resisting corrosion from acidic reagents. The front mask layer outside the region covered and protected by the acid-resistant paste can be etched away using the third acid agent, leaving only the patterned front mask layer on the light-receiving surface that remains unetched due to the protection of the acid-resistant paste. Then, by using the second alkali agent, the front doped layer, front intrinsic layer, and first dielectric layer located under the remaining front mask layer are protected from etching, while remaining the front doped layer, front intrinsic layer, and first dielectric layer that are unprotected by the front mask layer are etched away, meanwhile the acid-resistant paste on the front surface is also removed through alkali cleaning. Finally, the front mask layer on the light-receiving surface and the back mask layer on the back surface are removed using the third acid agent. Through the combined use of the three reagents described above, the first dielectric layer and the N-type doped amorphous silicon layer that are ultimately formed on the light-receiving surface are localized, only corresponding to and are located under the first electrode, while the second dielectric layer and the P-type doped polysilicon layer are formed on the entire back surface.

Additionally, when etching using the second alkali agent, a portion of the N-type diffusion layer is etched away to such an extent that this portion of the N-type diffusion layer is 0.05 µm to 0.15 µm thinner than the portion of the N-type diffusion layer in the preset region, thereby ensuring that the N-type doped amorphous silicon layer and the first dielectric layer are fully etched away, and guaranteeing that only the N-type doped amorphous silicon layer and the first dielectric layer in the preset region are protected. Ultimately, a patterned first passivating contact structure can be formed effectively. Consequently, the light absorption issues caused by residues of the first passivating contact structure remaining on the N-type diffusion layer can be avoided. For example, in an optional embodiment, the thickness of the N-type diffusion layer 2 can be 0.2 µm, and the N-type diffusion layer 2 covered by the first passivating contact structure 3 is 0.05 µm thicker than the N-type diffusion layer 2 not covered by the first passivating contact structure 3, meaning that a portion of the N-type diffusion layer with a thickness of about 0.05 µm is etched away.

In the annealing step, annealing is conducted in an atmosphere with a volume ratio of nitrogen to oxygen in a range from 1:1 to 8:1 at a temperature of 850 °C to 1000 °C for 90 minutes to 150 minutes. Under the above conditions, the N-type doped amorphous silicon layer can transform into an N-type doped polysilicon layer, while the P-type doped amorphous silicon layer can transform into a P-type heavily doped polysilicon layer, with a PN junction formed between the N-type substrate and the P-type heavily doped polysilicon layer. Concurrently, both the first dielectric layer and the second dielectric layer can break and develop through-holes for carrier transport.

The post-treatment step includes: forming a silicon oxide layer as the first passivation layer and then depositing a silicon nitride layer and/or a silicon oxynitride layer as the first anti-reflection layer on the N-type diffusion layer and the patterned N-type doped polysilicon layer, so that the first passivation layer and the first anti-reflection layer form the first function layer;
forming an aluminum oxide layer as the second passivation layer and then depositing a silicon nitride layer and/or a silicon oxynitride layer as the second anti-reflection layer on the P-type heavily doped polysilicon layer, so that the second passivation layer and the second anti-reflection layer form the second function layer.

In a third aspect, embodiments of the present application provide a photovoltaic module, including the solar cell as described in the first aspect, or the solar cell prepared by the method as described in the second aspect. By connecting multiple solar cells as described above in series and/or parallel and encapsulating the solar cells, a photovoltaic module can be formed.

The solar cells prepared in the present application and their performance will be further explained below in conjunction with examples, accompanying drawings, and testing data.

### Example 1

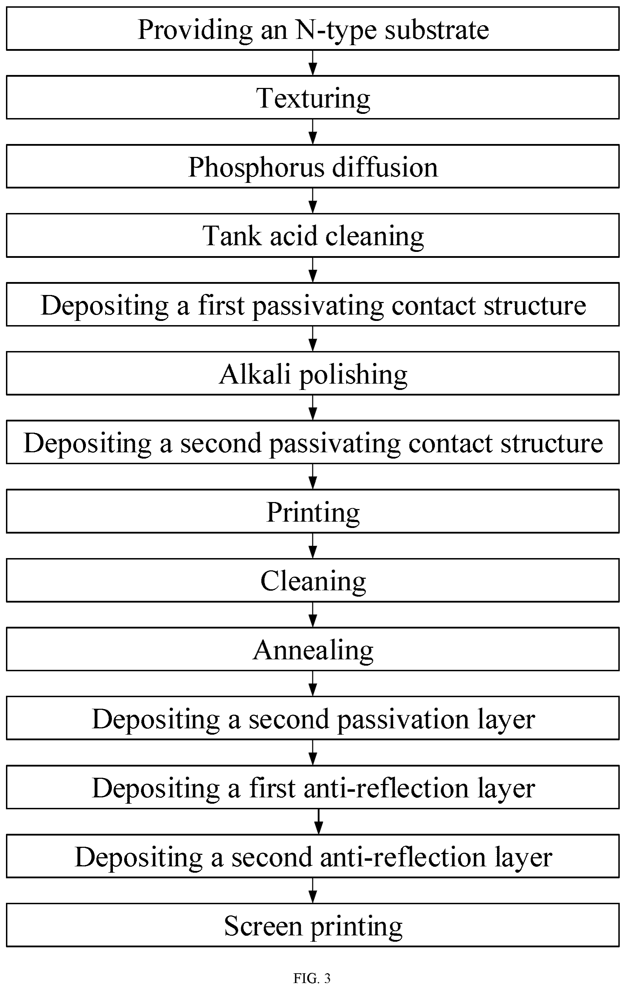

This example provides a solar cell. As shown in FIG. 3, which is a flowchart for preparing the solar cell of Example 1, the method for preparing the solar cell included the following steps:
Providing an N-type substrate: An N-type 182-size M10 silicon wafer was used as the N-type substrate, with a resistivity ranging from 0.4 Ω·cm to 1.6 Ω·cm and a minority carrier lifetime of >0.5 ms. The N-type substrate has a light-receiving surface and a back surface disposed opposite to each other, with the light-receiving surface serving as a light-incident surface.

Texturing: In a tank-type apparatus, the light-receiving surface of the N-type substrate was textured using sodium hydroxide and texturing additive TS40 in a volume ratio of 7:1 at a temperature of 80 °C for 7 minutes, during which the thickness reduction was controlled to 5 µm.

Phosphorus diffusion: The textured N-type substrate was placed in a phosphorus diffusion furnace. Using a nitrogen gas carrying phosphorus oxychloride gas and oxygen, a phosphorus source was deposited on the light-receiving surface of the N-type substrate and driven into the N-type substrate to form a phosphorus diffusion layer.

Tank acid cleaning: The N-type substrate with the phosphorus diffusion layer was immersed in a tank-type machine. The phosphosilicate glass layers on the light-receiving surface and the back surface of the N-type substrate were removed using a hydrofluoric acid solution in a volume percentage of 5%.

Depositing the first passivating contact structure: Five layers were deposited on the acid-cleaned light-receiving surface in a tubular PECVD apparatus under a pressure ranging from 2500 mTorr to 3500 mTorr at a temperature ranging from 350 °C to 450 °C.

Layer 1: Using PECVD, 8 standard liter per minute (SLM) to 15 SLM of N₂O was introduced to deposit a first dielectric layer of SiOx with a thickness of 1.5 nm, where the deposition time period was 140 seconds (s).

Layer 2: Using PECVD, SiH₄ and H₂ in a volume ratio of 1:2.5 were introduced to deposit a front intrinsic layer as an amorphous layer with a thickness of 5 nm to 40 nm, where the deposition time period was 40 s to 90 s.

Layer 3: Using PECVD, SiH₄, PH₃, and H₂ in a volume ratio of 1:0.4:2.5 were introduced to deposit a first front doped sublayer doped with element phosphorus as an amorphous silicon film with a thickness of 5 nm to 40 nm, where the deposition time period was 40 s to 90 s.

Layer 4: Using PECVD, SiH₄, PH₃, and H₂ in a volume ratio of 1:0.8:2.5 were introduced to deposit a second front doped sublayer doped with element phosphorus as an amorphous silicon layer with a thickness of 20 nm to 80 nm, where a deposition time period was 250 s to 350 s.

Layer 5: Using PECVD, SiH₄, NH₃, and N₂O in a volume ratio of 1:4:7 were introduced to deposit a silicon oxynitride layer as a front mask layer with a thickness of 5 nm to 40 nm, where a deposition time period was 60 s.

Alkali polishing: Using a chain-type HF machine, the front mask layer wrapping around the back surface was removed with a hydrofluoric acid solution in 5% volume percentage. Then the N-type substrate was transferred to a tank-type alkali polishing machine. The back surface of the N-type substrate was polished at a temperature of 80 °C for 7 minutes using sodium hydroxide and alkali polishing additive BP31 in a volume ratio of 3:1. Meanwhile, the second front doped sublayer, first front doped sublayer, front intrinsic layer, and first dielectric layer that wrap around the back surface and edges were removed.

Depositing the second passivating contact structure: Five layers were deposited on the back surface of the N-type substrate in a tubular PECVD apparatus under a pressure ranging from 2500 mTorr to 3500 mTorr at a temperature ranging from 350 °C to 450 °C.

Layer 1: Using PECVD, 8 SLM to 15 SLM of N₂O was introduced to deposit a second dielectric layer of SiOx with a thickness of 2.5 nm, where the deposition time period was 240 s.

Layer 2: Using PECVD, SiH₄ and H₂ in a volume ratio of 1:2.5 were introduced to deposit a back intrinsic layer as an amorphous layer with a thickness of 5 nm to 40 nm, where the deposition time period was 40 s to 90 s.

Layer 3: Using PECVD, SiH₄, TMB, and H₂ in a volume ratio of 1:0.3:2.5 were introduced to deposit a first back doped sublayer doped with element boron as an amorphous silicon film with a thickness of 10 nm to 80 nm, where the deposition time period was 80 s to 300 s.

Layer 4: Using PECVD, SiH₄, TMB, and H₂ in a volume ratio of 1:0.6:2.5 were introduced to deposit a second back doped sublayer doped with element boron as an amorphous silicon layer with a thickness of 150 nm to 350 nm, where a deposition time period was 1500 s to 3000 s.

Layer 5: Using PECVD, SiH₄, NH₃, and N₂O in a volume ratio of 1:4:7 were introduced to deposit a silicon oxynitride layer as a back mask layer with a thickness of 5 nm to 40 nm, where a deposition time period was 60 s.

Printing: A patterned acid-resistant paste was screen printed in the preset region of the front mask layer. The resulting pattern is similar or identical to the pattern of the first electrode to be screen printed, and the width of the printed acid-resistant paste is in a range from 20 µm to 110 µm, slightly wider than the width of the first electrode pattern to be screen-printed. After printing, the printed acid-resistant paste was dried at 150 °C to 250 °C for 10 s. The acid-resistant paste can protect the first dielectric layer and the N-type doped amorphous silicon layer, i.e., the amorphous silicon film layers such as the front mask layer, the front intrinsic layer, the first front doped sublayer, and the second front doped sublayer under the acid-resistant paste. The preset region corresponded to the region where the first electrode was to be disposed in the solar cell.

Cleaning: Using a chain-type apparatus, a portion of the front mask layer was removed using a hydrofluoric acid solution with a mass percentage of 5%, leaving only the patterned portion on the light-receiving surface unetched due to the protection of the acid-resistant paste. Then the N-type substrate was transferred into a tank-type texturing machine, the first dielectric layer, the N-type doped amorphous silicon layer, and the acid-resistant paste that were uncovered in the preset region on the light-receiving surface were etched away at a temperature of 80 °C for an etching time period of 2 minutes using sodium hydroxide and texturing additive TS40 in a volume ratio of 2:1. Then the N-type substrate was transferred into an acid tank, the back mask layer on the back surface and the front mask layer in the preset region on the light-receiving surface were etched away using a hydrofluoric acid solution with a volume percentage of 5%, so that a patterned first dielectric layer and an patterned N-type doped amorphous silicon layer were formed on the light-receiving surface of the N-type substrate in sequence, while a second dielectric layer and a P-type doped amorphous silicon layer were formed on the entire back surface of the N-type substrate in sequence.

Annealing: In a tubular annealing furnace, annealing was conducted at 850 °C for 120 minutes in an atmosphere of 10 SLM nitrogen gas and 5 SLM oxygen gas, so that the N-type doped amorphous silicon layer was transformed into an N-type doped polysilicon layer, the P-type doped amorphous silicon layer was transformed into a P-type heavily doped polysilicon layer, the first dielectric layer and the N-type doped polysilicon layer constituted the first passivating contact structure, the second dielectric layer and the P-type heavily doped polysilicon layer constituted the second passivating contact structure, and a PN junction was formed between the N-type substrate and the P-type heavily doped polysilicon layer. Additionally, due to the introduction of the oxygen gas, a silicon oxide layer was formed on the N-type diffusion layer and the first passivating contact structure on the light-receiving surface, serving as the first passivation layer.

Depositing the second passivation layer: Using atomic layer deposition (ALD), an aluminum oxide layer was deposited on the P-type heavily doped polysilicon layer with a thickness of 5 nm.

Depositing the first anti-reflection layer: Using PECVD, silicon nitride and silicon oxynitride films, as a composite first anti-reflection layer for anti-reflection, were deposited in sequence on the first passivation layer. The total thickness of the first anti-reflection layer was controlled to 75 nm to 85 nm, with a refractive index of 1.95 to 2.00.

Depositing the second anti-reflection layer: Using PECVD, silicon nitride, as a protective layer for back hydrogen passivation, was deposited on the second passivation layer The protective layer had a thickness of 75 nm to 80 nm and a refractive index of 2.10 to 2.15.

Screen printing: A silver paste was printed on the back surface and on the light-receiving surface sequentially, and then sintered at 840 °C to form the first electrode and the second electrode, respectively, wherein the second electrode extended through the first anti-reflection layer and the first passivation layer and formed an ohmic contact with the N-type doped polysilicon layer located in the preset region, and the first electrode extended through the second anti-reflection layer and the second passivation layer and formed an ohmic contact with the P-type heavily doped polysilicon layer located in the preset region. The cell was subjected to light injection at a temperature of 700 °C. The number of gridlines of the second electrode was 1.4 times that of gridlines of the first electrode.

In the solar cell of this example, the parameters of the N-type diffusion layer and the passivating contact structure, including layer thickness, doping concentration, through-hole parameters, etc., are detailed in Table 1 below.

The differences between Examples 2 to 16 and Example 1 are detailed in Table 1 below.

### Comparative Example 1

This comparative example provides a solar cell. The differences between the solar cell in this comparative example and that in Example 1 are only in the following aspects: in terms of the solar cell structure, no phosphorus diffusion layer was disposed on the light-receiving surface of the N-type substrate; in terms of the preparation method, after texturing, no phosphorus diffusion and tank acid cleaning steps were performed, and the first passivating contact structure was directly deposited.

### Comparative Example 2

This comparative example provides an N-type passivated contact solar cell. The method for preparing the same included the following steps:
Providing an N-type substrate: An N-type 182-size M10 silicon wafer was used as the N-type substrate. The N-type substrate has a light-receiving surface and a back surface disposed opposite to each other, with the light-receiving surface serving as a light-incident surface.

Texturing: In a tank-type apparatus, the light-receiving surface of the N-type substrate was textured using sodium hydroxide and texturing additive TS40 in a volume ratio of 7:1 at a temperature of 80 °C for 7 minutes, during which the thickness reduction was controlled to 5 µm.

Phosphorus diffusion: The textured N-type substrate was placed in a phosphorus diffusion furnace. Using phosphorus oxychloride gas and oxygen gas in a volume ratio of 3:1, a phosphorus source was deposited on the light-receiving surface of the N-type substrate at 830 °C and then driven into the N-type substrate for 1 hour at 1030 °C to form a PN junction. After diffusion, the sheet resistance was 120 Ω/sq to 140 Ω/sq.

Alkali polishing: Using a chain-type HF machine, the borosilicate glass (BSG) wrapping around the back surface during the boron diffusion was removed using a hydrofluoric acid solution with 50% volume percentage. Then the N-type substrate was transferred to a tank-type alkali polishing machine. The back surface of the N-type substrate was polished at a temperature of 80 °C for 7 minutes using sodium hydroxide and alkali polishing additive BP31 in a volume ratio of 3:1 to remove the PN junction wrapping around the back surface and edges during the boron diffusion.

Depositing first dielectric layer and poly-Si passivating film: Four layers were deposited on the light-receiving surface of the N-type substrate in a tubular PECVD apparatus under a pressure ranging from 2500 mTorr to 3500 mTorr at a temperature ranging from 350 °C to 450 °C.

Layer 1: Using PECVD, 8 SLM to 15 SLM of N₂O was introduced to deposit a first dielectric layer of SiOx with a thickness of 1 nm, where the deposition time period was 140 s.

Layer 2: Using PECVD, SiH₄ and H₂ in a volume ratio of 1:2.5 were introduced to deposit an intrinsic amorphous layer with a thickness of 20 nm, where the deposition time period was 65 s.

Layer 3: Using PECVD, SiH₄, PH₃, and H₂ in a volume ratio of 1:0.8:2.5 were introduced to deposit a phosphorus-doped amorphous silicon layer with a thickness of 100 nm, where the deposition time period was 500 s.

Layer 4: Using PECVD, SiH₄ and N₂O in a volume ratio of 1:4.5 were introduced to deposit SiOₓ layer with a thickness of 20 nm, where a deposition time period was 60 s.

Annealing: In a tubular annealing furnace, the silicon wafer was annealed at a temperature of 850 °C to 950 °C for 2700 s, i.e., 120 minutes, in an atmosphere of 5 SLM nitrogen gas, so that the crystal structure of the deposited amorphous silicon layer was transformed, forming a phosphorus-doped polysilicon layer.

Cleaning: Using a chain-type apparatus, the oxide layer on the light-receiving surface was removed using a hydrofluoric acid solution with a mass percentage of 5%. Then the silicon wafer was transferred into a tank-type alkaline polishing machine, the polysilicon layer deposited on and wrapped around the light-receiving surface during the annealing step was removed at a temperature of 80°C for 2 minutes using sodium hydroxide and alkaline polishing additive BP31 in a volume ratio of 2:1. Then the silicon wafer was transferred into an acid tank, the BSG layer on the light-receiving layer was removed using a hydrofluoric acid solution with a mass percentage of 5%.

Depositing aluminum oxide film and silicon nitride film on light-receiving surface: An aluminum oxide film with a thickness of 5 nm was deposited by atomic layer deposition (ALD) for passivation. Subsequently, a silicon nitride film, a silicon oxynitride film, and a silicon oxide film were sequentially deposited on the light-receiving surface by PECVD for anti-reflection, with a total thickness of 75 nm to 85 nm, and a refractive index of 1.95 to 2.00.

Depositing silicon nitride film on back surface: A silicon nitride film was deposited by PECVD for back hydrogen passivation, with a thickness of 75 nm to 80 nm and a refractive index of 2.10 to 2.15.

Screen printing: A silver paste was printed on the back surface and a silver-aluminum paste was printed on the light-receiving surface sequentially, and then sintered at a temperature of 840 °C to complete the formation of electrodes. The cell was subjected to light injection at a temperature of 700 °C.

That is to say, the preparation method of Comparative Example 2 involved forming the PN junction through drive-in boron diffusion on the light-receiving surface of the N-type substrate, then forming a passivating contact structure composed of a tunneling layer and a phosphorus-doped polysilicon layer through processes such as PECVD and annealing on the back surface of the N-type substrate, so that Comparative Example 2 formed a passivated contact solar cell with a PN junction on the light-receiving surface and a passivating contact structure on the back surface.

The differences between Comparative Examples 3 to 5 and Example 1 are detailed in Table 1 below.

### Performance testing:

Doping concentration was measured through conventional ECV equipment, i.e., the doping concentration distribution was measured using an electrochemical capacitance-voltage method.

Diameter and quantity of through-holes: The sample was etched with a tetramethylammonium hydroxide (TMAH) solution to remove the doped polysilicon. Subsequently, the sample without the doped polysilicon was placed under a scanning electron microscope (SEM) and observed to measure the diameter and quantity of the holes. The number of holes per unit area was calculated by dividing the quantity of the holes by the observed testing area.

**Table 1. Parameters of the N-type diffusion layers and passivating contact structures in solar cells**

| Group | Sheet resistance of | Thickness of N-type diffusion | Doping concentration of | Thickness of first dielectric | Thickness of N-type doped |
|---|---|---|---|---|---|
| | N-type diffusion layer (Ω/sq) | layer (µm) | N-type diffusion layer (atoms/cm³) | layer (nm) | polysilicon layer (nm) |
| Example 1 | 250 | 0.2 | 2.0×10¹⁹ | 1.5 | 100 |
| Example 2 | 180 | 0.2 | 2.9×10¹⁹ | 1.5 | 100 |
| Example 3 | 210 | 0.2 | 2.4×10¹⁹ | 1.5 | 100 |
| Example 4 | 300 | 0.2 | 1.5×10¹⁹ | 1.5 | 100 |
| Example 5 | 350 | 0.2 | 1.2×10¹⁹ | 1.5 | 100 |
| Example 6 | 250 | 0.3 | 1.5×10¹⁹ | 1.5 | 100 |
| Example 7 | 250 | 0.2 | 2.0×10¹⁹ | 1.0 | 100 |
| Example 8 | 250 | 0.2 | 2.0×10¹⁹ | 2.0 | 100 |
| Example 9 | 250 | 0.2 | 2.0×10¹⁹ | 1.5 | 50 |
| Example 10 | 250 | 0.2 | 2.0×10¹⁹ | 1.5 | 200 |
| Example 11 | 250 | 0.2 | 2.0×10¹⁹ | 1.5 | 100 |
| Example 12 | 250 | 0.2 | 2.0×10¹⁹ | 1.5 | 100 |
| Example 13 | 250 | 0.2 | 2.0×10¹⁹ | 1.5 | 100 |
| Example 14 | 250 | 0.2 | 2.0×10¹⁹ | 1.5 | 100 |
| Example 15 | 250 | 0.2 | 2.0×10¹⁹ | 1.5 | 100 |
| Example 16 | 250 | 0.2 | 2.0×10¹⁹ | 1.5 | 100 |
| Example 17 | 250 | 0.2 | 2.0×10¹⁹ | 1.5 | 100 |
| Comparati ve Example 1 | - | - | - | 1.5 | 100 |
| Comparati ve Example 3 | 250 | 0.2 | 2.0×10¹⁹ | 2.2 | 100 |
| Comparati ve Example 4 | 250 | 0.2 | 2.0×10¹⁹ | 1.5 | 100 |
| Comparative Example 5 | 250 | 0.2 | 2.0×10¹⁹ | 1.5 | 100 |

**Table 1-continued**

| Group | Diameter of through-hole (nm) | Quantity of through-holes (number/cm²) | Thickness of second dielectric layer (nm) | Thickness of P-type heavily doped polysilicon layer (nm) | Doping concentration of P-type heavily doped polysilicon layer (atoms/cm³) |
|---|---|---|---|---|---|
| Example 1 | 60 | 1×10⁶ | 2.5 | 300 | 1×10¹⁹ |
| Example 2 | 60 | 1×10⁶ | 2.5 | 300 | 1×10¹⁹ |
| Example 3 | 60 | 1×10⁶ | 2.5 | 300 | 1×10¹⁹ |
| Example 4 | 60 | 1×10⁶ | 2.5 | 300 | 1×10¹⁹ |
| Example 5 | 60 | 1×10⁶ | 2.5 | 300 | 1×10¹⁹ |
| Example 6 | 60 | 1×10⁶ | 2.5 | 300 | 1×10¹⁹ |
| Example 7 | 60 | 1×10⁶ | 2.5 | 300 | 1×10¹⁹ |
| Example 8 | 60 | 1×10⁶ | 2.5 | 300 | 1×10¹⁹ |
| Example 9 | 60 | 1×10⁶ | 2.5 | 300 | 1×10¹⁹ |
| Example 10 | 60 | 1×10⁶ | 2.5 | 300 | 1×10¹⁹ |
| Example 11 | 60 | 1×10⁶ | 2.2 | 300 | 1×10¹⁹ |
| Example 12 | 60 | 1×10⁶ | 3.5 | 300 | 1×10¹⁹ |
| Example 13 | 60 | 1×10⁶ | 2.5 | 250 | 1×10¹⁹ |
| Example 14 | 60 | 1×10⁶ | 2.5 | 350 | 1×10¹⁹ |
| Example 15 | 60 | 1×10⁶ | 2.5 | 300 | 5×10¹⁸ |
| Example 16 | 60 | 1×10⁷ | 2.5 | 300 | 1×10¹⁹ |
| Example 17 | 60 | 1×10⁵ | 2.5 | 300 | 1×10¹⁹ |
| Comparative Example 1 | 60 | 1×10⁶ | 2.5 | 300 | 1×10¹⁹ |
| Comparative Example 3 | 60 | 1×10⁶ | 2.5 | 300 | 1×10¹⁹ |
| Comparative Example 4 | 60 | 1×10⁶ | 1.7 | 300 | 1×10¹⁹ |
| Comparative Example 5 | 60 | 1×10⁶ | 2.5 | 300 | 1×10¹⁸ |

### Electrical Performance Testing

The solar cells of the above embodiments and comparative examples were subjected to performance testing. The performance parameters such as open-circuit voltage, short-circuit current, and fill factor were measured using Halm testing and sorting equipment. The Halm equipment can simulate sunlight and is equipped with electronic loads, data acquisition, and computing systems for testing the electrical performance of photovoltaic devices (including solar cells). The tested silicon wafers of the solar cells were of 182-size, and the calibrated light intensity was 1000 ± 5 W/m². The experimental results are shown in Table 2 below.

**Table 2. Performance testing results of solar cells**

| Sample No. | Open-circuit voltage (V) | Short-circuit current (mA/cm2) | Fill factor (%) | Photoelectric conversion efficiency (%) |
|---|---|---|---|---|
| Example 1 | 0.7288 | 41.56 | 85.35 | 25.85 |
| Example 2 | 0.7261 | 41.45 | 85.32 | 25.68 |
| Example 3 | 0.7274 | 41.51 | 85.36 | 25.77 |
| Example 4 | 0.7297 | 41.60 | 85.16 | 25.85 |
| Example 5 | 0.7299 | 41.61 | 84.93 | 25.79 |
| Example 6 | 0.7281 | 41.52 | 85.32 | 25.79 |
| Example 7 | 0.7258 | 41.56 | 85.26 | 25.72 |
| Example 8 | 0.7291 | 41.56 | 84.73 | 25.67 |
| Example 9 | 0.7252 | 41.56 | 85.07 | 25.64 |
| Example 10 | 0.7292 | 41.23 | 85.39 | 25.67 |
| Example 11 | 0.7258 | 41.55 | 85.32 | 25.73 |
| Example 12 | 0.7293 | 41.55 | 84.63 | 25.64 |
| Example 13 | 0.7281 | 41.58 | 84.91 | 25.71 |
| Example 14 | 0.7295 | 41.31 | 85.40 | 25.74 |
| Example 15 | 0.7265 | 41.55 | 84.93 | 25.64 |
| Example 16 | 0.7256 | 41.55 | 85.23 | 25.70 |
| Example 17 | 0.7291 | 41.55 | 84.59 | 25.63 |
| Comparative Example 1 | 0.7246 | 41.53 | 85.02 | 25.58 |
| Comparative Example 2 | 0.7184 | 41.45 | 84.32 | 25.11 |
| Comparative Example 3 | 0.7289 | 41.55 | 84.09 | 25.47 |
| Comparative Example 4 | 0.7255 | 41.53 | 84.67 | 25.51 |
| Comparative Example 5 | 0.7235 | 41.60 | 83.41 | 25.10 |

The performance testing results in Table 2 are analyzed as follows:
By comparing Example 1 with Comparative Examples 1 and 2, it can be seen that, compared with Comparative Example 2 which is a solar cell with a passivating contact structure on the back surface, Example 1 and Comparative Example 1 adopt a double-sided passivating contact structure and a back surface PN junction structure, which not only significantly reduces metallization-induced recombination on the light-receiving surface, leading to a substantial improvement in open-circuit voltage, but also achieves electrical conduction through the entire silicon wafer, reducing minority carrier transport losses at the front local metal contacts, and thus also improving the fill factor. Consequently, the photoelectric conversion efficiency is relatively high. Furthermore, Example 1 of the present application further incorporates a phosphorus diffusion layer as a front surface field upon Comparative Example 1. the phosphorus diffusion layer enhances the passivation effect on the light-receiving surface of the solar cell while also reducing the lateral transport resistance on the light-receiving surface. As a result, both the open-circuit voltage and the fill factor are improved. By combining the two aspects, the photoelectric conversion efficiency of the solar cell in Example 1 of the present application is improved more significantly, further reducing the cost per watt of the solar cell.

Furthermore, by comparing Examples 1, 7, and 8, it can be seen that the indicators such as the photoelectric conversion efficiency of the solar cell initially increase and then decrease as the thickness of the first dielectric layer increases. The highest photoelectric conversion efficiency is achieved when the thickness of the first dielectric layer is 1.5 nm. Further comparison with Comparative Example 3 shows that when the thickness of the first dielectric layer exceeds 2 nm, the open-circuit voltage, fill factor, and photoelectric conversion efficiency all decrease significantly. Thus, the first dielectric layer with a thickness less than or equal to 2 nm has a better effect on improving indicators such as photoelectric conversion efficiency. Especially, the first dielectric layer with a thickness of 1.5 nm exhibits more significant improvement.

By comparing Examples 1, 11, and 12 with Comparative Example 4, it can be seen that, in Comparative Example 4, the thickness of the second dielectric layer is 1.7 nm, but the corresponding photoelectric conversion efficiency is relatively low, indicating that the thickness of the second dielectric layer must be greater than 2 nm to effectively improve the photoelectric conversion efficiency of the solar cell. When the thickness of the second dielectric layer is 2.5 nm, as in Example 1, the improvement in photoelectric conversion efficiency is even more significant.

By comparing Example 1 and Comparative Example 5, it can be seen that, the doping concentration of the P-type conductive element in the P-type doped polysilicon layer can also significantly affect the performance of the solar cell, such as the photoelectric conversion efficiency. In Comparative Example 5, the doping concentration of the P-type conductive element in the P-type doped polysilicon layer is relatively low, which hinders effective selection of electrons and holes and affects the transport efficiency of holes as majority carriers on the back surface, thereby limiting the improvement in photoelectric conversion efficiency. Further comparison with Example 15 shows that when the doping concentration of the P-type element is higher, at 1×10¹⁹ atoms/cm³, it is more beneficial for improving photoelectric conversion efficiency.

Further comparison of Example 1 to Example 5 shows that the indicators such as the photoelectric conversion efficiency of the solar cell initially increase and then decrease as the sheet resistance of the N-type diffusion layer increases. The highest photoelectric conversion efficiency is achieved when the sheet resistance of the N-type diffusion layer is in a range from 250 Ω/sq to 300 Ω/sq. Additionally, comparison of Example 1 and Example 6 shows that, when the thickness of the N-type diffusion layer increases from 0.2 µm to 0.3 µm, the photoelectric conversion efficiency decreases, indicating that the preferred thickness of the N-type diffusion layer is 0.2 µm.

By comparing Example 1, Example 9, and Example 10, as well as comparing Example 1, Example 13, and Example 14, it can be seen that different thicknesses of the N-type doped polysilicon layer and the P-type doped polysilicon layer also affect the photoelectric conversion efficiency of the solar cell to varying degrees. The thickness of the N-type doped polysilicon layer has a particularly significant impact. Preferably , when the thickness of the N-type doped polysilicon layer is 100 nm and the thickness of the P-type doped polysilicon layer is 300 nm, the improvement in photoelectric conversion efficiency is more pronounced.

By comparing Example 1, Example 16, and Example 17, it can be seen that the number of through-holes in the second dielectric layer also affects the photoelectric conversion efficiency of the solar cell. In the present application, when the number of through-holes is 1×10⁶/cm³, the hole transport and passivation effects are balanced better.

### Ultraviolet Degradation Performance Testing

The solar cells of Example 1, Comparative Example 1, and Comparative Example 2 were subjected to ultraviolet degradation testing. After encapsulation, the cells were placed in an ultraviolet (UV) chamber and exposed to ultraviolet light at 70 °C. Following a cumulative UV exposure of 60 kWh, the post-UV exposure degradation values were measured. The Halm testing and sorting equipment was used to measure the photoelectric conversion efficiency of the cells before and after degradation.

**Table 3. UV60 ultraviolet degradation testing results of solar cells**

| Sample No. | Photoelectric conversion efficiency degradation rate (%) |
|---|---|
| Example 1 | 1.54% |
| Comparative Example 1 | 5.13% |
| Comparative Example 2 | 2.64% |

The performance testing results in Table 3 are analyzed as follows:
Compared with the solar cell in Comparative Example 1, where no N-type diffusion layer is disposed on the light-receiving surface, Example 1 exhibits a significantly reduced UV60 ultraviolet degradation rate due to the presence of the N-type diffusion layer on the light-receiving surface. Compared with the passivated contact solar cell in Comparative Example 2, Example 1 also exhibits a lower UV60 ultraviolet degradation rate, indicating that even though Comparative Example 2 uses an aluminum oxide film with good ultraviolet resistance as the passivation layer on the light-receiving surface, its anti-ultraviolet degradation capability is still inferior to that of Example 1 of the present application. The synergistic effect of the N-type diffusion layer and the silicon oxide layer can provide better resistance to ultraviolet degradation. Consequently, the embodiments of the present application not only improve the photoelectric conversion efficiency of the solar cell but also offer better stability against ultraviolet exposure, thereby enhancing the product reliability of the solar cell.

The solar cell, its preparation method, and the photovoltaic module disclosed in the embodiments of the present application have been described in detail hereinbefore. Specific examples are provided to illustrate the principles and implementation of the present application and the description of the above embodiments is only intended to aid understanding of the technical solutions and concept of the present application. Those of ordinary skill in the art can modify the specific embodiments and application scope based on the concept of the present application. In summary, the content of this specification should not be construed as limiting the scope of the present application.

## Claims

1. A solar cell, comprising:
an N-type substrate;
an N-type diffusion layer disposed on a light-receiving surface of the N-type substrate;
a patterned first passivating contact structure disposed on the N-type diffusion layer, the first passivating contact structure comprising a first dielectric layer disposed adjacent to the N-type diffusion layer and an N-type doped polysilicon layer disposed away from the N-type diffusion layer, wherein a thickness of the first dielectric layer is less than or equal to 2 nm;
a second passivating contact structure disposed on an entirety of an back surface of the N-type substrate, the second passivating contact structure comprising a second dielectric layer disposed adjacent to the N-type substrate and a P-type heavily doped polysilicon layer disposed away from the N-type substrate, with a PN junction being formed between the P-type heavily doped polysilicon layer and the N-type substrate, wherein a thickness of the second dielectric layer is greater than 2 nm, the second dielectric layer has a through-hole that communicates the N-type substrate with the P-type heavily doped polysilicon layer, and a doping concentration of a P-type conductive element in the P-type heavily doped polysilicon layer is in a range from 5×10¹⁸ atoms/cm³ to 3×10²⁰ atoms/cm³;
a first function layer disposed on surfaces of the N-type diffusion layer and the N-type doped polysilicon layer away from the substrate;
a second function layer disposed on a surface of the P-type heavily doped polysilicon layer away from the N-type substrate;
a first electrode extending through the first function layer and forming an ohmic contact with the N-type doped polysilicon layer, wherein a patterned region of the first passivating contact structure is disposed corresponding to a patterned region of the first electrode;
a second electrode extending through the second function layer and forming an ohmic contact with the P-type heavily doped polysilicon layer.

2. The solar cell according to claim 1, wherein a sheet resistance of the N-type diffusion layer is in a range from 200 Ω/sq to 350 Ω/sq.

3. The solar cell according to claim 1, wherein a thickness of the N-type diffusion layer is in a range from 0.05 µm to 0.5 µm.

4. The solar cell according to claim 1, wherein a doping concentration of an N-type conductive element in the N-type diffusion layer is in a range from 5×10¹⁸ atoms/cm³ to 1×10²⁰ atoms/cm³.

5. The solar cell according to claim 1, wherein a portion of the N-type diffusion layer covered by the first passivating contact structure is 0.05 µm to 0.15 µm thicker than a portion of the N-type diffusion layer not covered by the first passivating contact structure.

6. The solar cell according to claim 1, wherein a thickness of the N-type doped polysilicon layer is in a range from 30 nm to 200 nm.

7. The solar cell according to claim 1, wherein a thickness of the P-type heavily doped polysilicon layer is in a range from 200 nm to 400 nm.

8. The solar cell according to claim 1, wherein a diameter of the through-hole is in a range from 50 nm to 500 nm.

9. The solar cell according to claim 1, wherein a number of the through-holes is in a range from 1×10⁴/cm² to 1.6×10⁸/cm².

10. The solar cell according to claim 1, wherein a width of the first passivating contact structure is in a range from 20 µm to 110 µm.

11. The solar cell according to claim 1, wherein a quantity ratio of gridlines of the second electrode to gridlines of the first electrode is in a range from 1.2:1 to 1.6:1.

12. The solar cell according to any one of claims 1 to 11, wherein the first function layer comprises a first passivation layer disposed adjacent to the N-type diffusion layer and a first anti-reflection layer disposed away from the N-type diffusion layer.

13. The solar cell according to claim 12, wherein the first passivation layer is a silicon oxide layer, and the first anti-reflection layer is a silicon nitride layer, a silicon oxynitride layer, a silicon oxide layer, or any combination thereof.

14. The solar cell according to any one of claims 1 to 11, wherein the second function layer comprises a second passivation layer disposed adjacent to the P-type heavily doped polysilicon layer and a second anti-reflection layer disposed away from the P-type heavily doped polysilicon layer.

15. The solar cell according to claim 14, wherein the second passivation layer is an aluminum oxide layer, and the second anti-reflection layer is a silicon nitride layer, a silicon oxynitride layer, or a combination thereof.

16. A method for preparing the solar cell according to any one of claims 1 to 15, comprising following steps:
forming the N-type diffusion layer: diffusing the N-type conductive element on the light-receiving surface of the N-type substrate to obtain the N-type diffusion layer;
forming the passivating contact structure: forming the first dielectric layer and an N-type doped amorphous silicon layer in sequence on a surface of the N-type diffusion layer away from the N-type substrate, and forming the second dielectric layer and a P-type doped amorphous silicon layer in sequence on the back surface of the N-type substrate;
patterning treatment: printing a patterned paste in a preset region of the N-type doped amorphous silicon layer, then performing etching and cleaning to remove the first dielectric layer and the N-type doped amorphous silicon layer not covered in the preset region, and then removing the paste to retain the first dielectric layer and the N-type doped amorphous silicon layer covered in the preset region;
annealing: annealing the N-type substrate after the patterning treatment to convert the N-type doped amorphous silicon layer into the N-type doped polysilicon layer and to convert the P-type doped amorphous silicon layer into the P-type heavily doped polysilicon layer, wherein the first dielectric layer and the N-type doped polysilicon layer form the first passivating contact structure, the second dielectric layer and the P-type heavily doped polysilicon layer form the second passivating contact structure, and the PN junction is formed between the N-type substrate and the P-type heavily doped polysilicon layer;
post-treatment: forming the first function layer on the N-type diffusion layer and the patterned N-type doped polysilicon layer, forming the second function layer on the P-type heavily doped polysilicon layer, forming the first electrode on the first function layer wherein the first electrode extends through the first function layer and forms the ohmic contact with the N-type doped polysilicon layer, and forming the second electrode on the second function layer wherein the second electrode extends through the second function layer and forms the ohmic contact with the P-type heavily doped polysilicon layer.

17. The method according to claim 16, wherein the step of forming the N-type diffusion layer comprises: performing drive-in diffusion of the N-type conductive element on the light-receiving surface of the N-type substrate using nitrogen gas carrying oxygen and a gas source containing the N-type conductive element, thereby forming the N-type diffusion layer with a thickness in a range from 0.05 µm to 0.5 µm, wherein a sheet resistance of the N-type diffusion layer is in a range from 200 Ω/sq to 350 Ω/sq, and a doping concentration of the N-type conductive element in the N-type diffusion layer is in a range from 5×10¹⁸ atoms/cm³ to 1×10²⁰ atoms/cm³.

18. The method according to claim 17, wherein the step of forming the passivating contact structure comprises:
acid cleaning: subjecting the N-type substrate after diffusion treatment to acid cleaning using a first acid agent to remove silicon glass doped with the N-type conductive element and formed on the light-receiving surface and the back surface of the N-type substrate;
depositing the first dielectric layer, a front intrinsic layer, a front doped layer doped with the N-type conductive element, and a front mask layer in sequence on the N-type diffusion layer;
alkali polishing: removing the front mask layer wrapping the back surface using a second acid agent, then polishing the back surface of the N-type substrate using a first alkali agent, and removing the front doped layer, the front intrinsic layer, and the first dielectric layer that wrap the back surface and edges;
depositing the second dielectric layer, a back intrinsic layer, a back doped layer doped with the P-type conductive element, and a back mask layer in sequence on the back surface.

19. The method according to claim 18, wherein the front doped layer comprises a first front doped sublayer and a second front doped sublayer, each of the first front doped sublayer and the second front doped sublayer is doped with the N-type conductive element.

20. The method according to claim 18, wherein the back doped layer comprises a first back doped sublayer and a second back doped sublayer, each of the first back doped sublayer and the second back doped sublayer is doped with the P-type conductive element.

21. The method according to claim 18, wherein the step of patterning treatment comprises:
printing: printing a patterned acid-resistant paste on the front mask layer, wherein a patterned region of the acid-resistant paste corresponds to the preset region, and drying to cure the acid-resistant paste;
cleaning: etching away the front mask layer not covered in the preset region using a third acid agent, then removing the acid-resistant paste and the front doped layer, the front intrinsic layer, and etching away the first dielectric layer that are not covered in the preset region of the light-receiving surface using a second alkali agent, and removing the front mask layer and the back mask layer using a fourth acid agent.

22. The method according to claim 21, wherein in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

23. The method according to claim 16, wherein in the annealing step, annealing is conducted in an atmosphere with a volume ratio of nitrogen to oxygen in a range from 1:1 to 8:1 at a temperature of 850 °C to 1000 °C for 90 minutes to 150 minutes.

24. The method according to claim 16, wherein the post-treatment step comprises: forming a silicon oxide layer as the first passivation layer and then depositing a silicon nitride layer and/or a silicon oxynitride layer as the first anti-reflection layer on the N-type diffusion layer and the patterned N-type doped polysilicon layer, so that the first passivation layer and the first anti-reflection layer form the first function layer;
forming an aluminum oxide layer as the second passivation layer and then depositing a silicon nitride layer and/or a silicon oxynitride layer as the second anti-reflection layer on the P-type heavily doped polysilicon layer, so that the second passivation layer and the second anti-reflection layer form the second function layer.

25. A photovoltaic module, comprising the solar cell according to any one of claims 1 to 15, or the solar cell prepared by the method according to any one of claims 16 to 24.
